# EUROPEAN PATENT APPLICATION

(11) **EP 3 490 065 A1**
(43) Date of publication of application: **29.05.2019**
(21) Application number: 18207928.5
(22) Date of filing: 23.11.2018
(51) Int. Cl.: H01Q 1/32, G01S 13/93, H01Q 15/08, H01Q 19/06, H01Q 21/08

(54) **ANTENNA DEVICE**

(30) Priority: 27.11.2017 JP 2017226995
(71) Applicant: Panasonic Intellectual Property Management Co., Ltd., Osaka-shi, Osaka 540-6207 (JP)
(72) Inventor: SHIOZAKI, Ryosuke, Osaka-shi, Osaka 540-6207 (JP); YUI, Tomohiro, Osaka-shi, Osaka 540-6207 (JP); TAKAHASHI, Ken, Osaka-shi, Osaka 540-6207 (JP); SAITO, Noriaki, Osaka-shi, Osaka 540-6207 (JP); SUZUKI, Kouji, Osaka-shi, Osaka 540-6207 (JP); KASHINO, Yuichi, Osaka-shi, Osaka 540-6207 (JP)
(74) Representative: Grünecker Patent- und Rechtsanwälte PartG mbB

(57) **Abstract**

An antenna device having a case in which an opening is formed transmits and receives an electromagnetic wave through a cover member opposite to the opening. The antenna device includes a circuit board that has a first circuit board part having a component side opposite to the cover member and also has a second circuit board part extending in a direction perpendicular to the component side, the circuit board being disposed in the case. The antenna device also includes a transmission antenna that sends the electromagnetic wave toward the cover member, the transmission antenna being disposed on the component side, and a reception antenna that receives the electromagnetic wave, the reception antenna being disposed on the component side.

## Description

### BACKGROUND

### 1. Technical Field

The present disclosure relates to an antenna device.

### 2. Description of the Related Art

A known antenna device for radar use detects the position of an object (also referred to below as the target) in a non-contact manner by using electromagnetic waves in a frequency band for extremely high frequency waves and microwaves.

An antenna device is mounted in, for example, a vehicle for monitoring in various directions including forward monitoring, side monitoring in the forward direction, and side monitoring in the backward direction. This type of antenna device is mounted inside a cover member of a vehicle such as a bumper to protect the antenna device from a flying object external to the vehicle and maintain the beauty of the body of the vehicle. The antenna device is structured so as to send and receive an electromagnetic wave through the cover member.

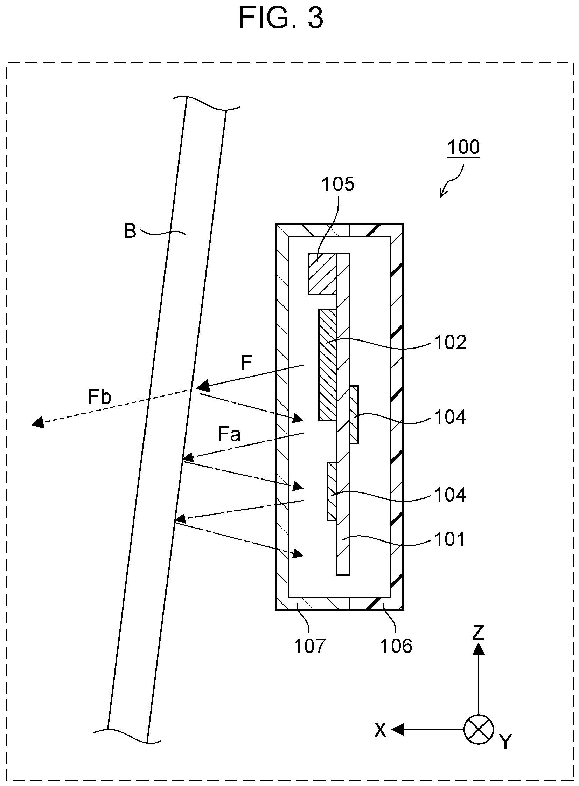

In general, an electromagnetic wave at a high frequency such as an extremely high frequency has the property that the electromagnetic wave transmits through an insulator (such as, for example, a resin material forming the bumper). However, the transmittance of the electromagnetic wave varies with the dielectric constant of the insulator, the thickness of the insulator, the angle of incidence on the insulator, and the like. Therefore, part of the electromagnetic wave sent from the antenna device is reflected on the inner wall of the cover member and causes noise when the antenna device detects an object. In particular, the reflected wave from the cover member may cause multi-reflection between the cover member and the circuit board on which antennas of the antenna device are placed (which will be described later with reference to Fig. 3).

Japanese Unexamined Patent Application Publication No. 2009-103457 describes a technology that suppresses multi-reflection between a cover member and an antenna plane by inclining the antenna plane, which opposes the cover member, at an angle so that a reflected wave from the cover member does not propagate toward the antenna plane.

### SUMMARY

The conventional technology described in Japanese Unexamined Patent Application Publication No. 2009-103457 is based on the premise that the antenna plane on the circuit board is placed so as to be opposite to the cover member. Therefore, it may not be possible to avoid the reflected wave from the cover member from arriving at the antenna plane depending on the shape of the cover member, so precision in object detection may become insufficient. Another problem with the conventional technology described in Japanese Unexamined Patent Application Publication No. 2009-103457 is that a direction in which an electromagnetic wave is sent is restricted depending on the shape of the cover member, so it is not possible to efficiently send an electromagnetic wave in a desired direction.

A problem with a general antenna device is that an output gain may be lowered because phases are cancelled due to multi-reflection between the antennal device and the cover (bumper) member.

One non-limiting and exemplary embodiment provides an antenna device that is more suitable for transmission and reception of an electromagnetic wave through a cover member.

In one general aspect, the techniques disclosed here feature an antenna device having a case in which an opening is formed, the antenna device transmitting and receiving an electromagnetic wave through a cover member opposite to the opening. The antenna device includes a circuit board that has a first circuit board part having a component side opposite to the cover member and also has a second circuit board part extending in a direction perpendicular to the component side, the circuit board being disposed in the case. The antenna device also includes a transmission antenna that sends the electromagnetic wave toward the cover member, the transmission antenna being disposed on the component side, and a reception antenna that receives the electromagnetic wave, the reception antenna being disposed on the component side.

It should be noted that general or specific embodiments may be implemented as a system, a method, an integrated circuit, a computer program, a storage medium, or any selective combination thereof.

The antenna device according to the present disclosure is more suitable for transmission and reception of an electromagnetic wave through a cover member.

Additional benefits and advantages of the disclosed embodiments will become apparent from the specification and drawings. The benefits and/or advantages may be individually obtained by the various embodiments and features of the specification and drawings, which need not all be provided in order to obtain one or more of such benefits and/or advantages

### BRIEF DESCRIPTION OF THE DRAWINGS

Fig. 1 illustrates an example of a state in which an antenna device in a conventional technology is mounted;
Fig. 2 is a sectional side elevation of the antenna device in the conventional technology;
Fig. 3 illustrates the motion of an electromagnetic wave when the antenna device in the conventional technology operates;
Fig. 4 is a sectional side elevation of an antenna device according to a first embodiment;
Fig. 5 is a front view of the antenna device according to the first embodiment;
Fig. 6 is a plan view of the antenna device according to the first embodiment;
Fig. 7A illustrates the motion of an electromagnetic wave when the antenna device according to the first operates;
Fig. 7B also illustrates the motion of an electromagnetic wave when the antenna device according to the first operates;
Fig. 8 is a graph indicating a result in simulation in which the radar performance of the antenna device according to the first embodiment was verified;
Fig. 9 is a sectional side elevation of an antenna device according to a second embodiment;
Fig. 10 is a sectional side elevation of an antenna device according to a third embodiment;
Fig. 11 is a sectional side elevation of an antenna device according to a fourth embodiment;
Fig. 12 is a front view of the antenna device according to the fourth embodiment;
Fig. 13 is a sectional side elevation of an antenna device according to a fifth embodiment;
Fig. 14 is a front view of an antenna device according to a sixth embodiment;
Fig. 15 is a sectional side elevation of an antenna device according to a seventh embodiment;
Fig. 16 is a front view of the antenna device according to the seventh embodiment;
Fig. 17 is a sectional side elevation of an antenna device according to an eighth embodiment;
Fig. 18 is a front view of the antenna device according to the eighth embodiment;
and
Fig. 19 illustrates an example in which an antenna device according to a ninth embodiment is used in communication.

### DETAILED DESCRIPTION

Embodiments of the present disclosure will be described below in detail with reference to the drawings. In the specification and drawings, the essentially same constituent elements are denoted by the same reference characters and repeated descriptions will be omitted.

In all drawings, to clarify positional relationships among constituent elements, a common orthogonal coordinate system (X, Y, Z) is indicated with respect to a forward direction in which the antenna device sends an electromagnetic wave to the outside of the antenna device (that is, a direction in which an object is detected). In the descriptions below, the positive X-axis direction represents the forward direction in which the antenna device sends an electromagnetic wave (simply referred to below as the forward direction), the positive Y-axis direction represents the right-side direction of the antenna device, and the positive Z-axis direction represents the upper direction of the antenna device (simplify referred to below as the upper direction).

### Underlying Knowledge Forming Basis of the Present Disclosure

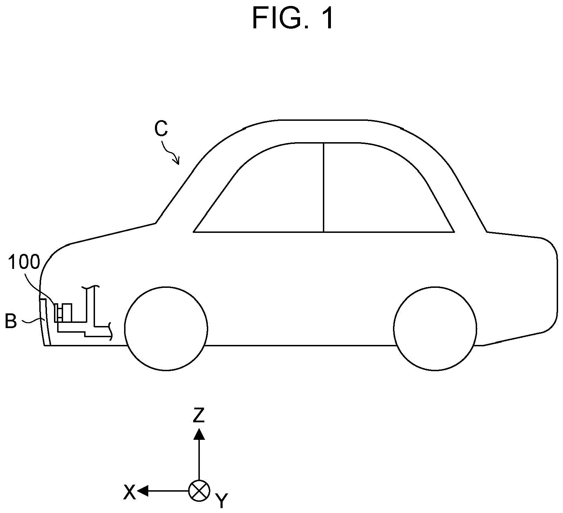

First, the effect, caused by an electromagnetic wave reflected on a cover member, on the antenna device will be described with reference to Figs. 1 to 3. In the descriptions below, a radar device mounted in a vehicle will be taken as an example of a target to which the antenna device in the present disclosure is applied.

Fig. 1 illustrates an example of a state in which an antenna device 100 in a conventional technology is mounted. Specifically, Fig. 1 illustrates an aspect in which the antenna device 100 in the conventional technology is mounted inside a cover member B of a vehicle C (in this example, the cover member B is a bumper member of the vehicle C). In Fig. 1, the positive Z-axis direction is equivalent to the upper direction of the vehicle C (direction perpendicular to the ground) and the positive X-axis direction is equivalent to a direction in which the vehicle C travels (direction parallel to the ground).

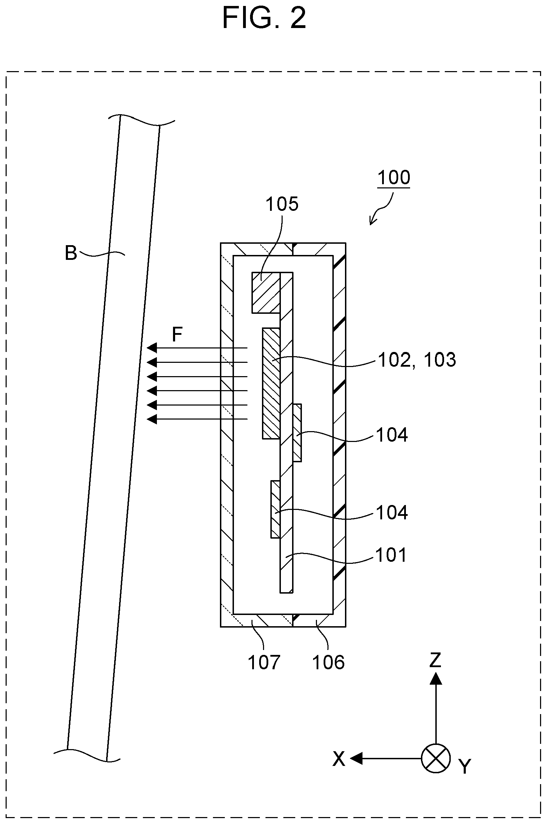

Fig. 2 is a sectional side elevation of the antenna device 100 in the conventional technology.

The antenna device 100 in the conventional technology has, for example, a circuit board 101, a transmission antenna 102, a reception antenna 103, a signal processing integrated circuit (IC) 104, a connector 105, a case 106, and a radome 107.

The transmission antenna 102, reception antenna 103, signal processing IC 104, and connector 105 are mounted on a component side of the circuit board 101.

Patch antennas or similar antennas that send and receive an electromagnetic wave in the direction normal to the component side of the circuit board 101 are usually used as the transmission antenna 102 and reception antenna 103.

To have the component side on which the transmission antenna 102 and reception antenna 103 face the forward direction of the vehicle C, the circuit board 101 is placed with the component side facing the cover member B. Thus, the orientation of the transmission antenna 102 and reception antenna 103 matches the forward direction of the antenna device 100. In Fig. 2, each arrow F indicated by a solid line represents an electromagnetic wave sent by the transmission antenna 102.

The circuit board 101 is stored in the case 106. The transmission antenna 102 sends an electromagnetic wave to the outside of the antenna device 100 through the radome 107 supported at the front surface of the case 106. The reception antenna 103 receives electromagnetic wave from the outside of the antenna device 100 through the radome 107 supported at the front surface of the case 106.

The antenna device 100, in the conventional technology, structured as described above sends and receives an electromagnetic wave through the cover member B (for example, a bumper member) and identifies the position of a target present outside the antenna device 100. The bumper member of the vehicle C is usually shaped so as to extend in a direction perpendicular to the ground, as illustrated in Fig. 2.

Fig. 3 illustrates the motion of an electromagnetic wave when the antenna 100 device in the conventional technology operates. Specifically, Fig. 3 illustrates an aspect in which the antenna device 100 sends and receives an electromagnetic wave in a direction parallel to the ground so that the electromagnetic wave transmits through the cover member B.

In Fig. 3, the arrow F indicated by a solid line represents an electromagnetic wave sent from the transmission antenna 102, each arrow Fa indicated by a dash-dot line represents a reflected wave resulting from the reflection of part of the electromagnetic wave sent from the transmission antenna 102 on the cover member B, and the arrow Fb indicated by a dotted line represents another part of the electromagnetic wave sent from the transmission antenna 102, the other part of the electromagnetic wave transmitting through the cover member B. For convenience of explanation, it will be assumed that there is no reflection on the radome 107.

First, when an electromagnetic wave is sent from the transmission antenna 102, the electromagnetic wave transmits through the radome 107 and arrives at the cover member B. Most of the electromagnetic wave that has arrived at the cover member B transmits through the cover member B and propagates toward the target outside the vehicle. However, part of the electromagnetic wave reflects on the surface of the cover member B, transmits through the radome 107 again, and returns to the circuit board 101.

The electromagnetic wave that has returned to the circuit board 101 reflects on the circuit board 101 again, transmits through the radome 107, and propagates toward the cover member B. The electromagnetic wave repeatedly reflects between the cover member B and the component side of the circuit board 101, and part of the electromagnetic wave arrives at the reception antenna 103 (this reflection may also be referred to as multi-reflection).

An electromagnetic wave that has caused multi-reflection as described above has a phase different from the phase of the reflected wave from the target, so the electromagnetic wave and the reflected wave from the target are mutually strengthened and weakened according to the angle of the reflected wave that arrives at the reception antenna 103. As a result, the electromagnetic wave that causes multi-reflection forms an angle at which the reception antenna 103 cannot detect the reflected wave from the target (or at which sensitivity in detection is lowered) at some spots. Since the electromagnetic wave that has caused multi-reflection has a phase different from the phase of the reflected wave from the target when the electromagnetic wave arrives at the reception antenna 103, the electromagnetic wave causes error in the inference of a direction toward the target.

Although not illustrated, another part of the electromagnetic wave that reflects on the surface of the cover member B repeatedly reflects between the cover member B and other regions of the body of the vehicle and returns to the reception antenna 103 through a complex propagation path (this type of electromagnetic wave may also be referred to as the turnaround wave). This turnaround wave enters the reception antenna 103 with a certain amount of delay. In signal processing, however, it is difficult to distinguish between the turnaround wave and the reflected wave from the target. Therefore, due to the turnaround wave, a target that is not present in practice may be detected.

### First embodiment

### Structure of the antenna device

Reduction in the effects of the multi-reflection and turnaround wave described above will be described below.

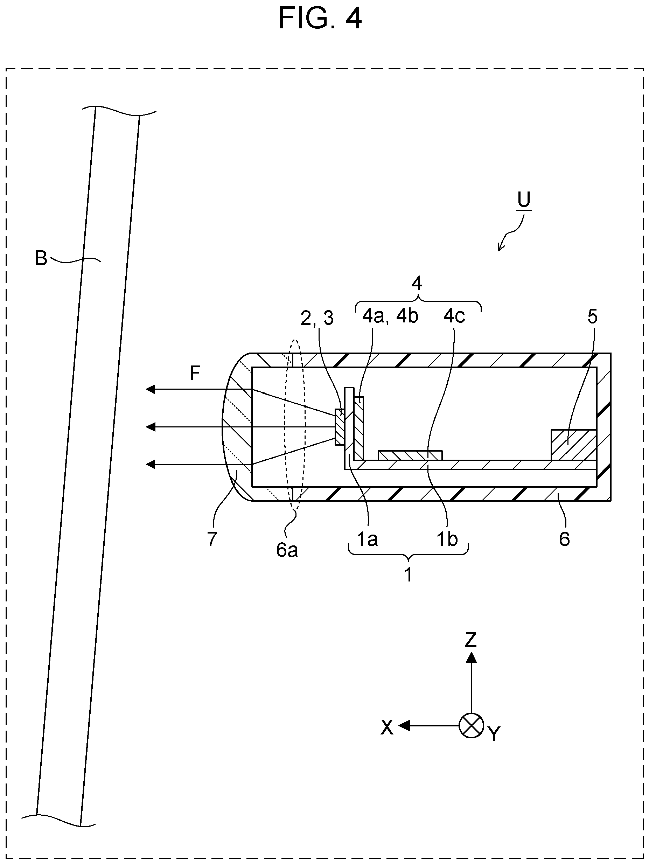

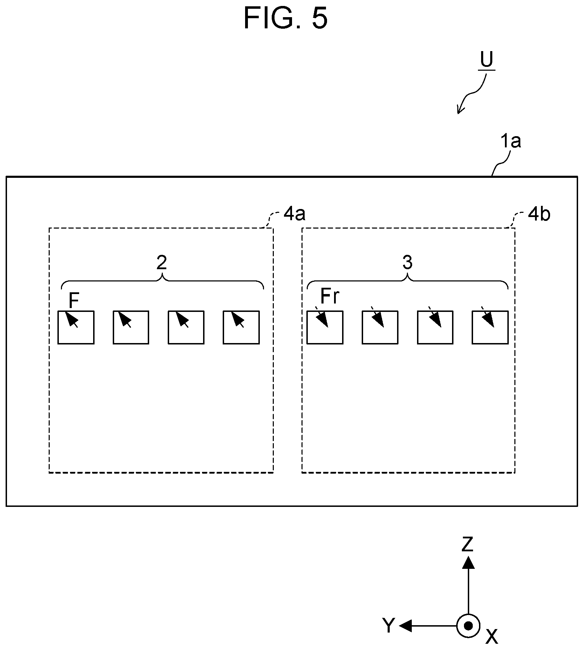

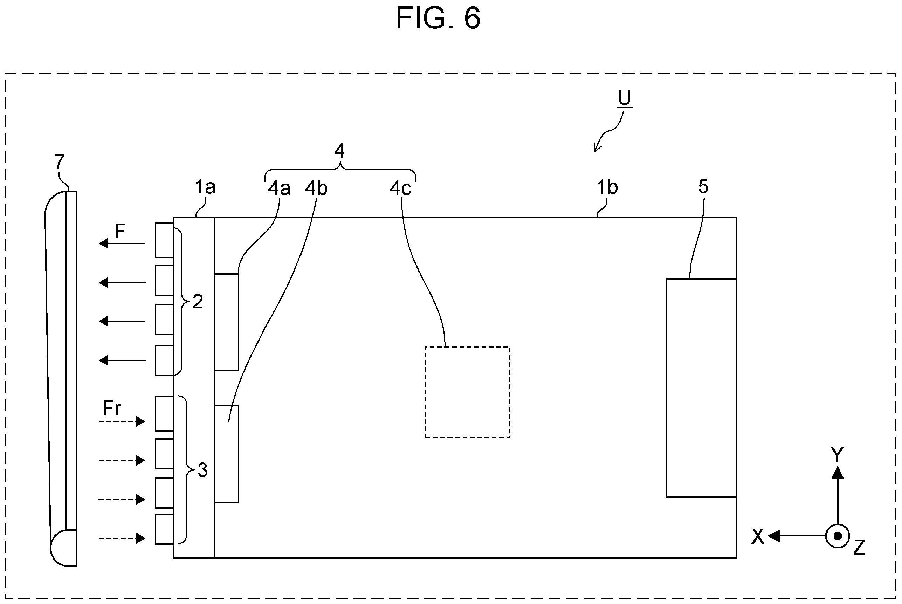

Fig. 4 is a sectional side elevation of an antenna device U according to this embodiment. Fig. 5 is a front view of the antenna device U according to this embodiment when the front component side of a first circuit board part 1a is viewed from in front of the first circuit board part 1a). Fig. 6 is a plan view of the antenna device U according to this embodiment.

Each arrow F indicated by a solid line in Figs. 4, 5, and 6 represents an electromagnetic wave sent from a transmission antenna 2. Each arrow Fr indicated by a dotted line in Figs. 5 and 6 represents a reflected wave from the target. In Figs. 4, 5, and 6, a structure that supports the antenna device U in the vehicle C is not illustrated.

The antenna device U according to this embodiment is applied to, for example, a radar device as with the antenna device 100 in the conventional technology. That is, the antenna device U is placed inside the cover member B of the vehicle C (in this example, the cover member B is the bumper member), and sends and receives an electromagnetic wave through the cover member B (see Fig. 1).

The antenna device U according to this embodiment has a circuit board 1, the transmission antenna 2, a reception antenna 3, a signal processing IC 4, a connector 5, a case 6, and a dielectric lens 7.

In the antenna device U according to this embodiment, the circuit board 1 is composed of a first circuit board part 1a placed so that one component side of it faces the forward direction and a second circuit board part 1b placed so that its component sides extend in the front-back direction. The antenna device U according to this embodiment is structured so that an electromagnetic wave is sent and received through a window 6a, which is an opening made in the case 6, which accommodates the circuit board 1.

With this structure, a region itself through which a reflected wave from the cover member B enters the case 6 is restricted to restrain part of the reflected wave from arriving at the reception antenna 3.

On the circuit board 1, the transmission antenna 2, reception antenna 3, signal processing IC 4, connector 5, and the like are mounted. Specifically, on the front or rear component side of the circuit board 1, the transmission antenna 2, reception antenna 3, signal processing IC 4, connector 5, and the like are mounted, and wires (not illustrated) that mutually connect these components (transmission antenna 2, reception antenna 3, signal processing IC 4, connector 5, and the like) are formed as patterns.

The circuit board 1 has the first circuit board part 1a placed so that one component side of it faces the front with respect to the forward direction toward a region eligible for detection of the object and also has the second circuit board part 1b placed so that its component sides extend in the front-back direction (substantially X direction). That is, the first circuit board part 1a is placed so that one component side of it opposes the cover member B, and the second circuit board part 1b is placed so that the direction in which its component sides extend crosses (for example, is orthogonal to) the direction in which the cover member B extends.

On the first circuit board part 1a, the transmission antenna 2 and reception antenna 3 are placed (in this example, a signal processing IC 4a for use in an extremely high frequency band is further placed for the transmission antenna 2 and a signal processing IC 4b for use in an extremely high frequency band is further placed for the reception antenna 3), as illustrated in Fig. 5. On the second circuit board part 1b, circuit components (not illustrated) other than the transmission antenna 2 and reception antenna 3 (in this example, these components are a signal processing IC 4c for use in a baseband, the connector 5, an electrolytic capacitor, and the like) are placed. The second circuit board part 1b and first circuit board part 1a are electrically connected to each other with wires (not illustrated).

That is, in the antenna device U according to this embodiment, the circuit board 1 is structured so as to be separated into the first circuit board part 1a and second circuit board part 1b so that only a region needed to place the transmission antenna 2 and reception antenna 3 (that is, a region on a component side of the first circuit board part 1a) opposes the cover member B.

A positional relationship between the first circuit board part 1a and the second circuit board part 1b may be such that the first circuit board part 1a is placed in a front region on a component side of the second circuit board part 1b or in front of the second circuit board part 1b. Thus, when the transmission antenna 2 sends an electromagnetic wave and the reception antenna 3 receives the electromagnetic wave, it is possible to prevent the electromagnetic wave from being shielded by circuit components mounted on the second circuit board part 1b.

There is no limitation on the materials of the first circuit board part 1a and second circuit board part 1b of the circuit board 1 if the materials are rigid circuit board materials. For example a flat printed circuit board (PCB) can be used. A multi-layer circuit board or a semiconductor circuit board in which the signal processing IC 4 is incorporated may be used as the first circuit board part 1a and second circuit board part 1b. If the second circuit board part 1b and first circuit board part 1a are electrically connected to each other, they may be formed integrally or as separate components.

The transmission antenna 2 is placed on the front component side of the first circuit board part 1a. The transmission antenna 2 sends an electromagnetic wave forward (in the positive X-axis direction). Similarly, the reception antenna 3 is placed on the front component side of the first circuit board part 1a. The reception antenna 3 receives a reflected wave from in front of the circuit board 1 (in the positive X-axis direction). That is, the transmission antenna 2 has a directivity property effective when an electromagnetic wave is sent in a direction substantially normal to the component sides of the first circuit board part 1a, and the reception antenna 3 has a directivity property effective when an electromagnetic wave is received in a direction substantially normal to the component sides of the first circuit board part 1a.

However, the directivity properties of the transmission antenna 2 and reception antenna 3 may be inclined by an angle of 3 degrees or more in the ±Y direction or ±Z direction with respect to the direction normal to the component sides of the first circuit board part 1a. Thus, it is possible to suppress multi-reflection between the cover member B and the relevant component side of the first circuit board part 1a.

Patch antennas having a directivity property in a direction normal to the component sides of the first circuit board part 1a are typically used as the transmission antenna 2 and reception antenna 3. When an antenna, such as a patch antenna, that has a directivity property in the direction normal to a component side is used, a high gain can be easily obtained.

The transmission antenna 2 and reception antenna 3 only need to be structured by using conductive patterns formed on the circuit board 1, so slot antennas and the like can also be used as the transmission antenna 2 and reception antenna 3. Alternatively, the transmission antenna 2 and reception antenna 3 may be structured as a single antenna used for both transmission and reception of an electromagnetic wave.

The transmission antenna 2 and reception antenna 3 are each composed of a plurality of antenna elements formed on a component side of the first circuit board part 1a (in Fig. 5, the transmission antenna 2 is composed of four patch antennas placed along the Y direction and the reception antenna 3 is composed of four patch antennas placed along the Y direction).

An electromagnetic wave sent from the transmission antenna 2 is converted to a plane wave by the dielectric lens 7 and is then sent toward an outside region in front of the antenna device U (in this example, in a substantially horizontal direction). When a reflected wave of the electromagnetic wave sent from the transmission antenna 2 is reflected by a target outside the antenna device U and then returns, the reflected wave is focused by the dielectric lens 7 and then propagates to the reception antenna 3. In a wall region of the case 6, the transmission antenna 2 and reception antenna 3 are placed behind the window 6a, which allows the electromagnetic wave to transmit through the window 6a.

The signal processing IC 4 (equivalent to a signal processor in the present disclosure) sends a driving signal at a high frequency (for example, in an extreme high frequency band) to the transmission antenna 2 to have the transmission antenna 2 send an electromagnetic wave (for example, an electromagnetic wave, in a pulse compression method, formed from a pulse sequence or an electromagnetic wave in the form of a frequency-modulated continuous wave).

The signal processing IC 4 also receives a reflected wave signal from the reception antenna 3 and performs object detection processing (for example, demodulation processing and frequency analysis processing) to detect a distance to the target (for example, a vehicle or a person), a direction in which the target is present, the intensity of reflection by the target, a speed, and the like. The signal processing IC 4 infers a direction in which the target is present by, for example, using a method by which a direction in which an electromagnetic wave sent from the transmission antenna 2 is scanned or differences among the reception phases of reflected wave signals received by an array of radiating elements of the reception antenna 3 are detected.

Detailed descriptions of processing performed by the signal processing IC 4 will be omitted because the processing is similar to processing performed by a known structure. Part of the processing performed by the signal processing IC 4 may be executed by an external device such as a vehicle engine control unit (ECU).

The main component of the signal processing IC 4 is, for example, a known microcomputer composed of a central processing unit (CPU), a read-only memory (ROM), a random-access memory (RAM), and the like. The signal processing IC 4 further has a driving circuit that creates a driving signal at a high frequency that is sent to the transmission antenna 2, a detection circuit that performs reception processing on the reflected wave signal from the reception antenna 3, and the like. Of course, part of the signal processing IC 4 can be implemented by only a special hardware circuit that lacks a CPU and the like.

As an example of the signal processing IC 4, Figs. 4, 5, and 6 illustrate the signal processing IC 4a, for use by the transmission antenna 2, that performs signal processing in an extreme high frequency band, the signal processing IC 4b, for use by the reception antenna 3, that performs signal processing in an extreme high frequency band, and the signal processing IC 4c that performs signal processing in a baseband, these ICs being separate chips.

The signal processing ICs 4a and 4b that perform signal processing in an extreme high frequency band are placed on, for example, the rear component side of the first circuit board part 1a as illustrated in Figs. 4, 5, and 6 so as to reduce the lengths of the wires between the transmission antenna 2 and the signal processing IC 4a and between the reception antenna 3 and the signal processing IC 4b. The signal processing IC 4c that performs signal processing in a baseband may be placed at any position. In Fig. 6, the signal processing IC 4c is placed on the front component side of the second circuit board part 1b.

The connector 5 connects the signal processing IC 4 and an external device (for example, a vehicle ECU mounted on the vehicle C) together so that communication is possible between them.

The case 6 accommodates the circuit board 1 and supports the dielectric lens 7 in front of the circuit board 1. Typically, the case 6 accommodates the circuit board 1 in a substantially sealed state.

To make the case 6 compact, its outside shape matches the outside shape of the circuit board 1 (for example, a rectangular parallelepiped shape). The length of the case 6 in the front-back direction (±X directions) is set to the sum of the length of the second circuit board part 1b in the front-back direction and a predetermined width margin. The length of the case 6 in the up-down direction (±Z directions) is set to the sum of the length of the first circuit board part 1a in the up-down direction and a predetermined width margin. That is, the length of the case 6 in the up-down direction is shorter than its length in the front-back direction.

As the material of the case 6, a metal member (for example, an aluminum material) is used to, for example, prevent a reflected wave from the cover member B from entering the case 6, improve a property to dissipate heat from the circuit board 1, and improve electromagnetic compatibility (EMC) performance. When reduction in cost and weight is emphasized, however, a resin may be used the material of the case 6. Alternatively, the case 6 and dielectric lens 7 may be integrally formed from the same resin material. However, the case 6 may be formed from a material having higher thermal conductivity than the material of the dielectric lens 7.

When an electromagnetic wave is sent in the positive X-axis direction from the transmission antenna 2 toward the dielectric lens 7, the electromagnetic wave transmits through the window 6a. When an electromagnetic wave is sent in the negative X-axis direction from the dielectric lens 7 toward the reception antenna 3, the electromagnetic wave transmits through the window 6a. The dielectric lens 7 is attached to the case 6 so as to cover the window 6a. The diameter of the window 6a is set to, for example, the length of an opening from which a predetermined gain is obtained when an electromagnetic wave is sent or received (that is, a beam width when an electromagnetic wave is sent from the transmission antenna 2).

A wall region, included in the wall part of the case 6, that does not allow an electromagnetic wave to transmit through the wall region (that is, a region other than the window 6a) may extend to, for example, a position in front of positions at which the transmission antenna 2 and reception antenna 3 are placed, as illustrated in Fig. 4. Thus, it is possible to further restrain a reflected wave from the cover member B from entering the case 6.

The dielectric lens 7, which is supported in front of the circuit board 1, narrows the beam of an electromagnetic wave sent from the transmission antenna 2 and directs the narrowed beam to an outside region in front of the antenna device U. The dielectric lens 7 focuses a reflected wave, which is the electromagnetic wave that had been sent and has returned from the target, onto the reception antenna 3. In other words, the transmission antenna 2 and reception antenna 3 are each placed at the focal point of the dielectric lens 7. The dielectric lens 7 is structured so as to, for example, narrow the electromagnetic wave sent from the transmission antenna 2 to the extent that the electromagnetic wave is converted to a plane wave.

The dielectric lens 7 improves a gain at the time when the transmission antenna 2 sends an electromagnetic wave and when the reception antenna 3 receives the electromagnetic wave, and restrains the reflected wave from the cover member B from entering the reception antenna 3 (which will be described later in detail). The dielectric lens 7 also functions as a radome that protects the transmission antenna 2 and reception antenna 3.

A single convex lens having a convex shape on the front surface (in the positive X-axis direction) can be typically used as the dielectric lens 7. However, a double convex lens, a ball lens, a Fresnel lens, a combination of these lenses, a combination of a concave lens and these lenses, or the like may be used. Alternatively, the rear surface of the dielectric lens 7 may be convex in the negative X-axis direction.

There is no limitation on the material of the dielectric lens 7. For example, an acrylic resin, a tetrafluoroethylene resin, a polystyrene resin, a polycarbonate resin, a polybutylene terephthalate resin, a polyphenylene resin, a polypropylene resin, a syndiotactic polystyrene resin, an acrylonitrile-butadiene-styrene (ABS) resin, or the like is used.

The dielectric lens 7 according to this embodiment is shaped so as to be convex only in the positive X-axis direction so that the beam of the electromagnetic wave is not narrowed in the Y direction (see Fig. 6). In other words, the cross section of the side surface of the dielectric lens 7 has almost the same shape at any position in the Y direction. This prevents electromagnetic waves sent from a plurality of antenna elements of the transmission antenna 2, which are placed along the Y direction, from being directed differently when the electromagnetic waves arrive at the reception antenna 3, which would otherwise lower precision in object detection (for example, lower precision due to mutual interference or lower precision due to a change in phase difference).

In addition, to make the electromagnetic waves sent from the plurality of antenna elements of the transmission antenna 2 identifiable, the plurality of antenna elements of the transmission antenna 2 may be operated in a time-division manner or the electromagnetic waves sent from the plurality of antenna elements of the transmission antenna 2 may be polarized in different directions. Motion of an electromagnetic wave when the antenna device operates

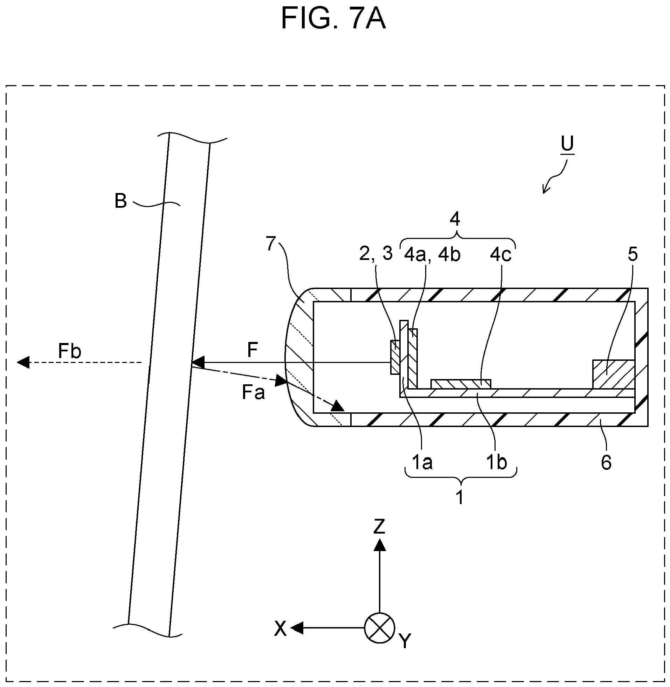

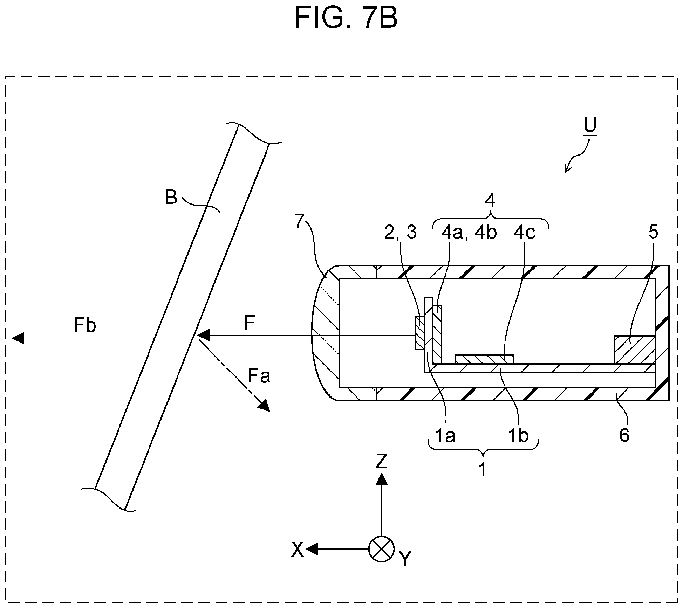

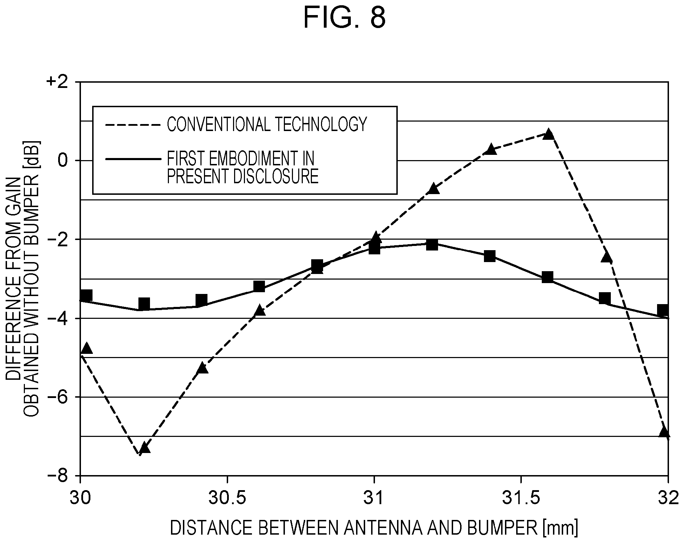

Next, the motion of an electromagnetic wave when the antenna device U according to this embodiment will be described with reference to Figs. 7A, 7B, and 8.

Figs. 7A and 7B illustrate the motion of an electromagnetic wave when the antenna device U according to this embodiment operates. Specifically, Fig. 7A illustrates the motion of an electromagnetic wave in a case in which the positional relationship between the antenna device U and the cover member B is the same as in Fig. 4, and Fig. 7B illustrates the motion of an electromagnetic wave in a case in which the positional relationship between the antenna device U and the cover member B is different from Fig. 4 for convenience of explanation.

In Figs. 7A and 7B, the arrow F indicated by a solid line represents an electromagnetic wave that has been sent from the antenna device U, the arrow Fa indicated by a dash-dot line represents a reflected wave resulting from the reflection of part of the electromagnetic wave sent from the transmission antenna 2 on the cover member B, and the arrow Fb indicated by a dotted line represents an electromagnetic wave that has transmitted through the cover member B, the electromagnetic wave being part of the electromagnetic wave sent from the transmission antenna 2.

Part of the electromagnetic wave F sent from the transmission antenna 2 is reflected on the cover member B as described with reference to Fig. 3, after which the part of the electromagnetic wave F becomes the reflected wave Fa that returns to the antenna device U.

Unlike the antenna device 100 in the conventional technology, however, the circuit board 1 in the antenna device U according to this embodiment is divided into the first circuit board part 1a and second circuit board part 1b and a region opposing the cover member B is limited to the component side region of the first circuit board part 1a. In the antenna device U according to this embodiment, the transmission antenna 2 and reception antenna 3 placed on the component side of the first circuit board part 1a send and receive an electromagnetic wave through the window 6a (that is, a region to which the dielectric lens 7 is attached) formed in the case 6.

Therefore, most of the reflected wave Fa from the cover member B does not enter the case 6 but scatters upward and downward. The reflected wave Fa that has impinged on the case 6 also scatters toward the back of the case 6 without being reflected again toward the cover member B.

In addition, in the antenna device U according to this embodiment, the transmission antenna 2 and reception antenna 3 on the circuit board 1 send and receive an electromagnetic wave trough the dielectric lens 7.

Therefore, even if part of the reflected wave Fa from the cover member B arrives the dielectric lens 7, the part enters a non-plane portion of the dielectric lens 7 and scatters without being focused onto the reception antenna 3. That is, in a case as well in which the reflected wave Fa that has arrived at the dielectric lens 7 transmits through the dielectric lens 7, if the reflected wave Fa arrives at an angle other than a predetermined angle, the reflected wave Fa is not focused at the position at which the reception antenna 3 is placed, so the reflected wave Fa scatters in the case 6 or flies to the outside of the case 6 and scatters. When reflection occurs on the dielectric lens 7, the reflection angle of the reflected Fa changes by an amount equal to the angle of the surface of the dielectric lens 7 (if, for example, the dielectric lens 7 is an convex lens, its reflection angle changes in a direction away from the antenna device U), so the reflected wave Fa scatters without causing multi-reflection.

As described above, in the antenna device U according to this embodiment, the reflected wave Fa from the cover member B scatters without causing multi-reflection between the cover member B and the circuit board 1 (and between the cover member B and the case 6). The antenna device U according to this embodiment also restrains the reflected wave Fa from the cover member B from turning around and then arriving at the position at which the reception antenna 3 is placed. By contrast, the reflected wave from the object follows the path through which the sent electromagnetic wave follows and arrives at the position at which the reception antenna 3 is placed, without being impeded by the above structure.

Fig. 8 is a graph indicating a result in simulation in which the radar performance of the antenna device U according to this embodiment was verified.

In this simulation in the antenna device U, the radio field intensity (that is, the gain) of the reflected wave from a predetermined target, the reflected wave being received by the reception antenna 3, was calculated with different values of the distance between the cover member B and the transmission antenna 2 (and between the cover member B and the reception antenna 3).

In Fig. 8, the solid-line curve indicates simulation results for the antenna device U (see Fig. 4) according to this embodiment and the dotted-line curve indicates simulation results for the antenna device 100 (see Fig. 2) in the conventional technology. The solid-line curve and dotted-line curve were each obtained by plotting simulation results.

The vertical axis of the graph in Fig. 8 indicates the radio field intensity of the reflected wave, which came from the predetermined target and was received by the reception antenna 3 (here, a comparison was made with radio field intensity in a case in which the cover member B did not intervene). The horizontal axis of the graph indicates the distance between the cover member B and the dielectric lens 7.

As seen from Fig. 8, in the antenna device 100 in the conventional technology, a region in which radio field intensity is reduced appeared at a plurality of positions (in Fig. 8, a 30.25-mm position and a 32.0-mm position) depending on the distance between the cover member B and the transmission antenna 102. That is, in the antenna device 100 in the conventional technology, the graph indicates that the reflected wave Fa from the cover member B interferes with the reflected wave from the target and detection precision is lowered at some spots, due to a slight difference in the distance between the cover member B and the transmission antenna 102.

In the antenna device U according to this embodiment, however, there was no region in which radio field intensity is lowered depending on the distance between the cover member B and the transmission antenna 2. That is, since in the antenna device U according to this embodiment, it is possible to restrain the interference of the reflected wave Fa from the cover member B with the reflected wave from the target, detection precision remains substantially the same independently of the positional relationship between the cover member B and the transmission antenna 2. This indicates that, in the antenna device U according to this embodiment, radar performance involved particularly in the inference of a direction toward the position at which the target is present.

### Effects

As described above, in the antenna device U according to this embodiment, the circuit board 1 is composed of the first circuit board part 1a, which is placed so that one of the component sides faces forward, and the second circuit board part 1b, which is placed so that the component sides extend in the front-back direction. The antenna device U according to this embodiment is structured so that an electromagnetic wave is sent and received through the window 6a formed in the case 6, which accommodates the circuit board 1.

Thus, it is possible to restrict a region itself through which a reflected wave from the cover member B enters the case 6. This can restrain part of the reflected wave from the cover member B from arriving at the reception antenna 3 due to, for example, multi-reflection of the reflected wave between the cover member B and the antenna device U (specifically, the circuit board 1, case 6, or the like, for example). As a result, the antenna device U according to this embodiment can obtain a uniform gain in all directions, enabling precision in direction inference to be improved. Thus, it is also possible to restrain phases from being cancelled due to multi-reflection between the antenna device U and the cover member B (bumper member) and thereby restrain an output gain from being lowered. The antenna device U according to this embodiment is especially useful in that the effects described above can be obtained regardless of the shape of the cover member B.

Thus, since patch antennas having a directivity property in a direction normal to the component sides of the circuit board 1, for example, can be used as the transmission antenna 2 and reception antenna 3, the antenna device U can obtain a high gain and can easily infer a direction in object detection.

In the antenna device U according to this embodiment, an electromagnetic wave is sent to and received from the outside of the antenna device U through the dielectric lens 7. Thus, it is possible to improve a gain and is also possible to further restrain a reflected wave from the cover member B from arriving at the reception antenna 3.

In the antenna device U according to this embodiment, the signal processing IC 4a electrically connected to the transmission antenna 2 and the signal processing IC 4b electrically connected to the reception antenna 3 are mounted on the rear component side of the first circuit board part 1a. Thus, it is possible to shorten the length of the wire between the transmission antenna 2 and the signal processing IC 4a and the length of the wire between the reception antenna 3 and the signal processing IC 4b. Therefore, it is possible to suppress the warp of the waveforms of analog signals in the wires, contributing to improving a signal-to-noise (S/N) ratio. It is also possible to reduce loss in electric power in the wires.

### Second embodiment

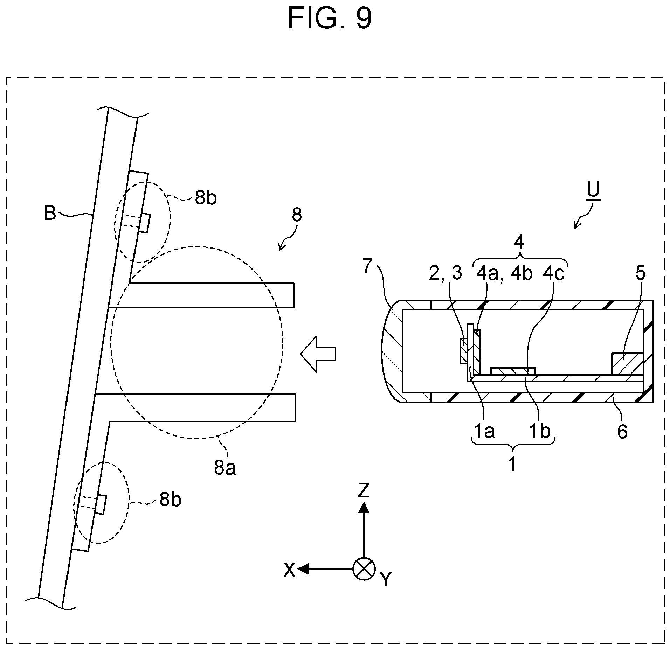

Next, an example of the structure of an antenna device U according to a second embodiment will be described with reference to Fig. 9.

Fig. 9 is a sectional side elevation of the antenna device U according to the second embodiment.

The antenna device U according to this embodiment differs from the antenna device U according to the first embodiment in that the antenna device U according to this embodiment has a bracket 8 that secures the case 6 and the like to the cover member B. Descriptions of structures common to the first embodiment and second embodiment will be omitted (this is also true for other embodiments described below).

The bracket 8 secures the case 6 to the cover member B to define a direction in which the antenna device U sends and receives an electromagnetic wave.

The bracket 8 has, for example, a storage portion 8a in which the antenna device U is stored and fixing portions 8b secured to the cover member B.

The storage portion 8a has, for example, a cylindrical shape that enables the case 6 to be inserted into the storage portion 8a from its front surface (that is, the surface on which the dielectric lens 7 is attached). In the storage portion 8a, storage space matching the outside shape of the case 6 is formed. The storage portion 8a has an opening through which the antenna device U sends and receives an electromagnetic wave, the opening being formed in a region at which the dielectric lens 7 at the front of the antenna device U is placed.

Each fixing portion 8b is secured to the cover member B with a double-sided adhesive tape, bolts, or the like. Any method can be used to secure the fixing portion 8b to the cover member B. Furthermore, ultrasonic welding or the like may be used.

The bracket 8 having a structure described above secures the case 6 to the cover member B so that, for example, a direction in which the antenna device U sends and receives an electromagnetic wave is parallel to the ground. Thus, it is possible to detect a target present around the vehicle C.

The material of the bracket 8 is, for example, an electromagnetic wave absorbing material or a material including an electromagnetic wave absorbing material. Thus, it is possible to further restrain a turnaround wave from entering the window 6a in the case 6.

The structure of the bracket 8 may have an adjustment mechanism (that uses, for example, a pin joint and a fixing pin) that can vary the angle of a direction in which an electromagnetic wave is sent and received. When the adjustment mechanism is used, fine adjustment of the direction in which an electromagnetic wave is sent and received is also possible.

With the antenna device U according to this embodiment, mechanical stability can be maintained and an electromagnetic wave can be sent and received in a desired direction (for example, a direction parallel to the ground).

### Third embodiment

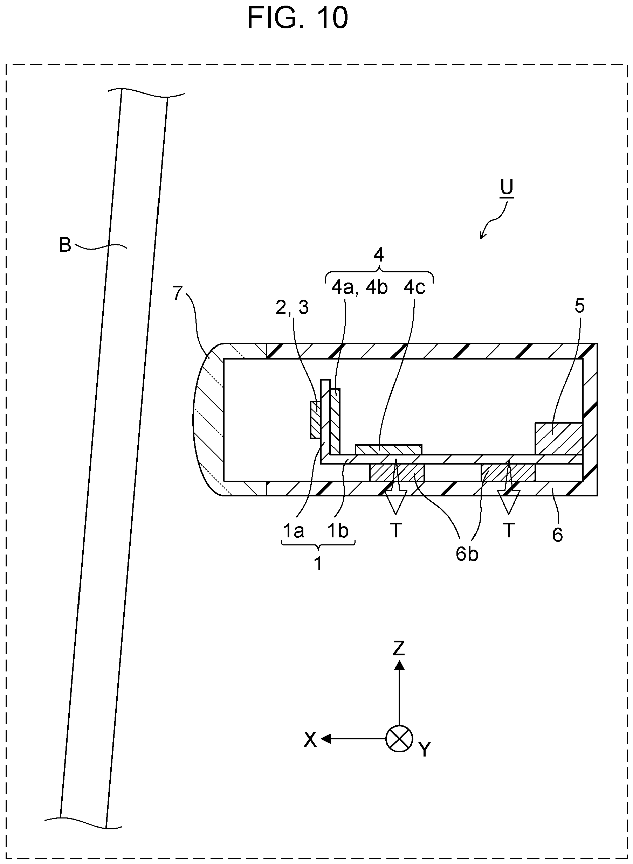

Next, an example of the structure of an antenna device U according to a third embodiment will be described with reference to Fig. 10.

Fig. 10 is a sectional side elevation of the antenna device U according to the third embodiment.

The antenna device U according to this embodiment differs from the antenna device U according to the first embodiment in that the antenna device U according to this embodiment has connecting parts 6b that thermally bond the case 6 to the circuit board 1 or circuit components mounted on the circuit board 1.

Fig. 10 illustrates a state in which the connecting parts 6b thermally bond the wall of the case 6 to the circuit board 1. Each hallow arrow T in the drawing represents a flow of heat from the circuit board 1.

In this embodiment, a metal member having a high heat dissipation property, for example, is used as the material of the case 6. Each connecting part 6b thermally bonds the wall of the case 6 to the circuit board 1 or circuit components mounted on the circuit board 1.

The connecting part 6b can have any structure. The connecting part 6b may be formed integrally with the wall of the case 6. Alternatively, the connecting part 6b may be formed from, for example, silicone grease, an adhesive based on an epoxy resin or the like. Alternatively, the connecting part 6b may be a putty-, rubber-, gell-, or compound-like member.

With the antenna device U according to the present disclosure, the entire region of the case 6 except the front can be formed as a wall region that can dissipate heat. Therefore, the wall region, capable of dissipating heat, of the case 6 can be made larger when compared with the antenna device 100 (see Fig. 2) in the conventional technology. Accordingly, in the improvement of a property to dissipate heat from the circuit board 1, the structure in which the connecting parts 6b are used to dissipate heat from the case 6 is especially effect in the antenna device U.

The antenna device U according to the present disclosure can improve a property to dissipate heat from the circuit board 1 and the like.

### Fourth embodiment

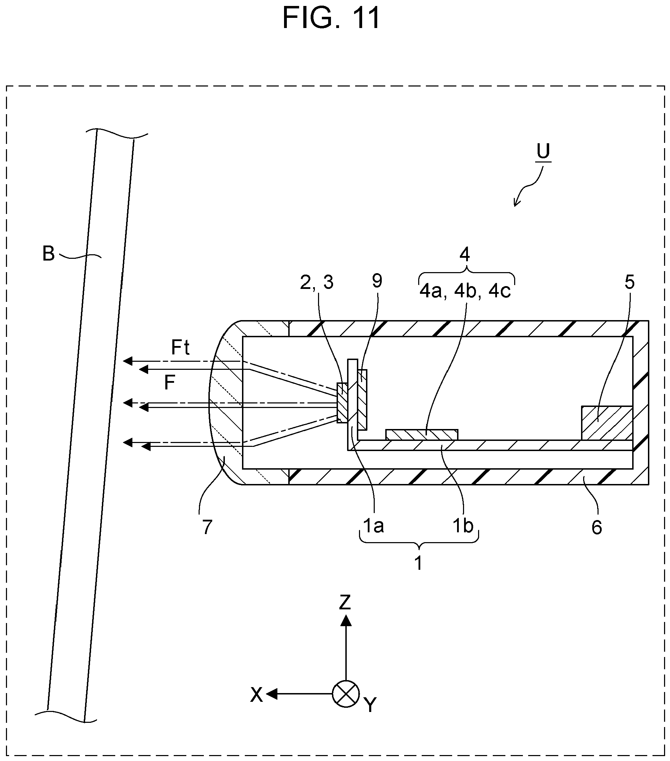

Next, an example of the structure of an antenna device U according to a fourth embodiment will be described with reference to Fig. 11.

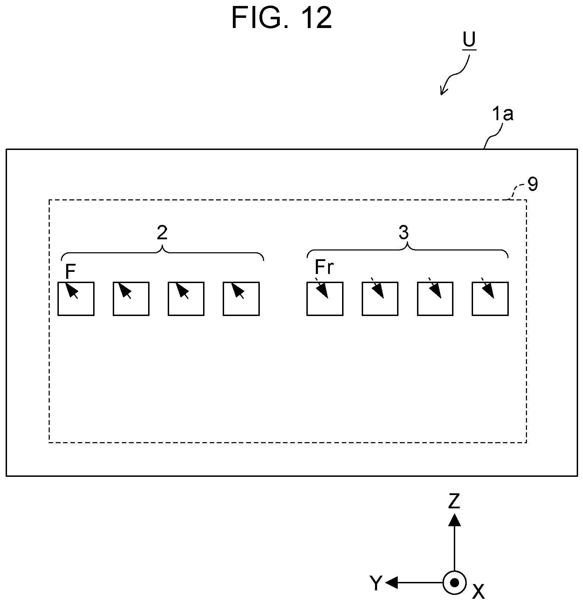

Fig. 11 is a sectional side elevation of the antenna device U according to the fourth embodiment. Fig. 12 is a front view of the antenna device U according to the fourth embodiment when the front component side of the first circuit board part 1a is viewed from in front of the first circuit board part 1a.

The antenna device U according to this embodiment differs from the antenna device U according to the first embodiment in that on the first circuit board part 1a, a reflector 9 is placed on the side opposite to the side on which the transmission antenna 2 is mounted, (that is, on the rear component side of the first circuit board part 1a).

On the same side as the rear surface of the transmission antenna 2, the reflector 9 reflects the back lobe of an electromagnetic wave sent from the transmission antenna 2. Thus, the direction in which the back lobe of the electromagnetic wave sent from the transmission antenna 2 proceeds is changed to the forward direction. The back lobe is then combined with the main lobe F of the electromagnetic wave sent from the transmission antenna 2 (see the arrows Ft indicated by dash-dot-dot lines in Fig. 11).

The reflector 9 may be formed by attaching a metal plate to the rear component side of the first circuit board part 1a. Alternatively, when a multi-layer circuit board is used as the first circuit board part 1a, the reflector 9 may be formed as an intermediate electric conductor layer of the multi-layer circuit board or an electric conductor layer on the rear surface of the multi-layer circuit board.

The reflector 9 may be placed at, for example, a position at which the reflector 9 covers the entire regions of the rear surfaces of the transmission antenna 2 and reception antenna 3 on the first circuit board part 1a (see Fig. 12). When placed on the rear surface of the reception antenna 3, the reflector 9 has the effect of increasing the reception efficiency.

Alternatively, the reflector 9 may be placed, for example, at a distance of about λg/4 from the position of the transmission antenna 2 so that the phase of the back lobe Ft that is reflected on the reflector 9 and proceeds forward substantially matches the phase of the main lobe F. Here, λg represents the equivalent wavelength of an electromagnetic wave when it passes through the circuit board 1. The value of λg is obtained from the equation λg = λ0/sqrt(er), where λ0/ is the free-space wavelength of the electromagnetic wave sent from the transmission antenna 2 and er is the specific inductive capacity of the circuit board 1.

The antenna device U according to the present disclosure can further improve the gain.

### Fifth embodiment

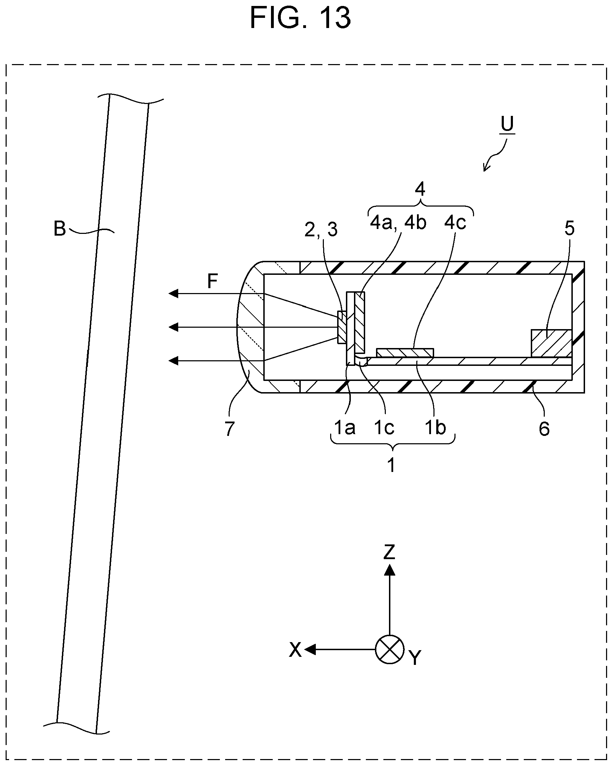

Next, an example of the structure of an antenna device U according to a fifth embodiment will be described with reference to Fig. 13.

Fig. 13 is a sectional side elevation of the antenna device U according to the fifth embodiment.

The antenna device U according to this embodiment differs from the antenna device U according to the first embodiment in that the first circuit board part 1a and second circuit board part 1b are placed separately from each other and are electrically connected to each other through a flexible wiring board 1c.

The flexible wiring board 1c is a flexible circuit board on which wires are formed as patterns. The flexible wiring board 1c electrically connects the wires of the first circuit board part 1a and the wires of the second circuit board part 1b to each other.

In other words, the signal processing IC 4a and signal processing IC 4b placed on the rear component side of the first circuit board part 1a send and receive electric signals to and from the signal processing IC 4c through the flexible wiring board 1c.

Since the antenna device U according to this embodiment uses the flexible wiring board 1c, the antenna device U can more flexibly adjust the positions at which to place the first circuit board part 1a and second circuit board part 1b.

### Sixth embodiment

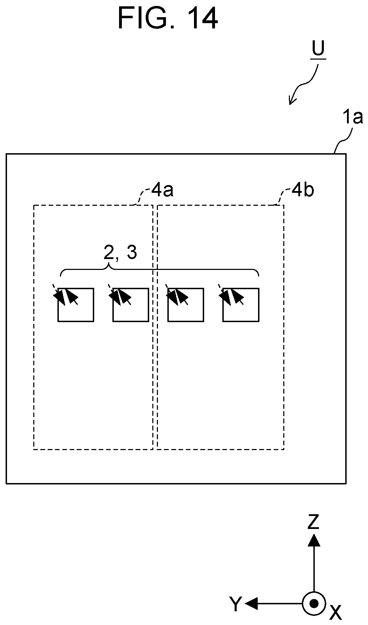

Fig. 14 is a front view of an antenna device U according to a sixth embodiment.

The antenna device U according to this embodiment differs from the antenna device U according to the first embodiment in that the transmission antenna 2 and reception antenna 3 are formed as a common antenna (in this example, four patch antennas).

In other words, the antenna device U according to this embodiment causes antenna elements to perform an electromagnetic wave transmission operation and an electromagnetic wave reception operation in a time-division manner under control of the signal processing IC 4. Transmission and reception of an electric signal between an antenna element and the transmission circuit (signal processing IC 4 for use for transmission) and transmission and reception of an electric signal between another antenna element and the reception signal (signal processing IC 4 for use for reception) are switched by, for example, a switch or circulator in a time-division manner.

With the antenna device U according to this embodiment, the number of antenna elements placed in the Y direction can be reduced. Thus, the size of the window 6a of the case 6 can be reduced in the Y direction. This can further restrain the reflected wave from the cover member B from entering the case 6.

### Seventh embodiment

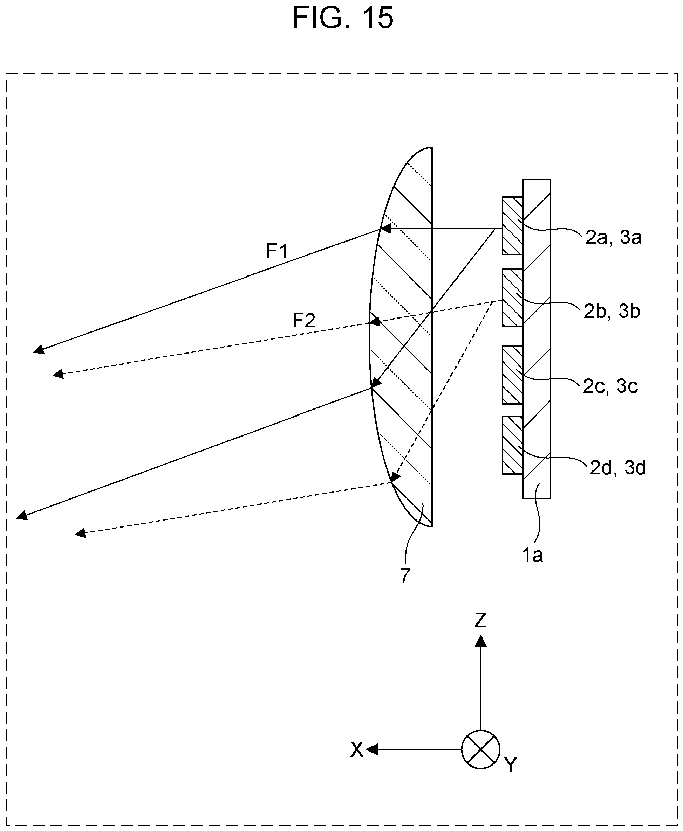

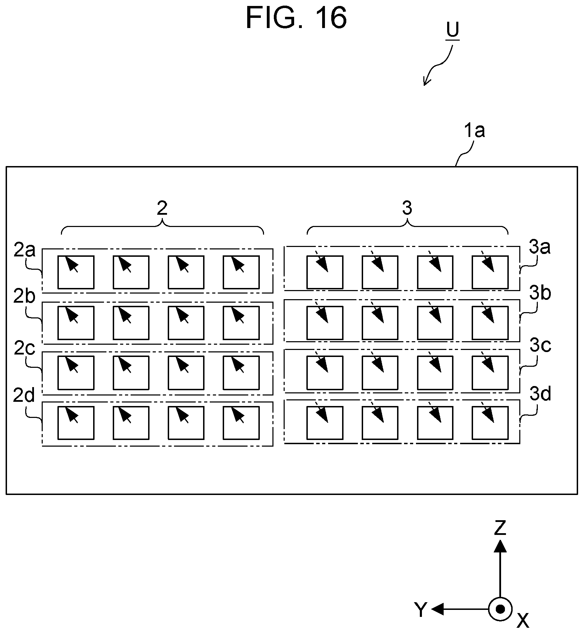

Next, an example of the structure of an antenna device U according to a seventh embodiment will be described with reference to Figs. 15 and 16.

Fig. 15 is a sectional side elevation of the antenna device U according to this embodiment. Fig. 16 is a front view of the antenna device U according to this embodiment when the front component side of the first circuit board part 1a is viewed from in front of the first circuit board part 1a. In Figs. 15 and 16, only the region of the first circuit board part 1a is illustrated as an enlarged view for convenience of explanation.

The antenna device U according to this embodiment differs from the antenna device U according to the first embodiment in that the antenna elements of the transmission antenna 2 and reception antenna 3 are arrayed in the Z direction as well.

In the transmission antenna 2 according to this embodiment, four antenna elements (in this example, patch antennas) are placed in each column in the Z direction and four antenna elements placed in each row in the Y direction, that is, antenna elements are placed in a 4 × 4 matrix. Similarly in the reception antenna 3, four antenna elements (in this example, patch antennas) are placed in each column in the Z direction and four antenna elements placed in each row in the Y direction, that is, antenna elements are placed in a 4 × 4 matrix.

The signal processing IC 4 according to this embodiment divides the antenna elements of the transmission antenna 2 into four groups along the Z direction (in Fig. 16, these groups are represented as regions 2a, 2b, 2c, and 2d enclosed by dash-dot-dot lines) and operates one group at a time in a time-division manner.

Similarly, the signal processing IC 4 divides the antenna elements of the reception antenna 3 into four groups along the Z direction (in Fig. 16, these groups are represented as regions 3a, 3b, 3c, and 3d enclosed by dash-dot-dot lines) and operates one group at a time in a time-division manner.

When executing object detection processing, the signal processing IC 4 uses transmission antennas 2 and reception antennas 3 at the same height in the Z direction. Specifically, the antenna element group in the region 2a in the transmission antenna 2 and the antenna element group in the region 3a in the reception antenna 3 are used as a set, the antenna element group in the region 2b in the transmission antenna 2 and the antenna element group in the region 3b in the reception antenna 3 are used as a set, the antenna element group in the region 2c in the transmission antenna 2 and the antenna element group in the region 3c in the reception antenna 3 are used as a set, and the antenna element group in the region 2d in the transmission antenna 2 and the antenna element group in the region 3d in the reception antenna 3 are used as a set.

When electromagnetic waves are sent from antenna elements in the transmission antenna 2 at different heights to the dielectric lens 7, beams are narrowed but their transmission directions can be deviated. In Fig. 15, each arrow F1 indicated by a solid line represents an electromagnetic wave sent from the antenna element group in the region 2a in the transmission antenna 2, and each arrow F2 indicated by a dotted line represents an electromagnetic wave sent from the antenna element group in the region 2b in the transmission antenna 2.

The antenna device U according to this embodiment can restrain the interference of electromagnetic waves and can further expand an object detection range (that is, a range in which a direction is inferred in the Z direction).

### Eighth embodiment

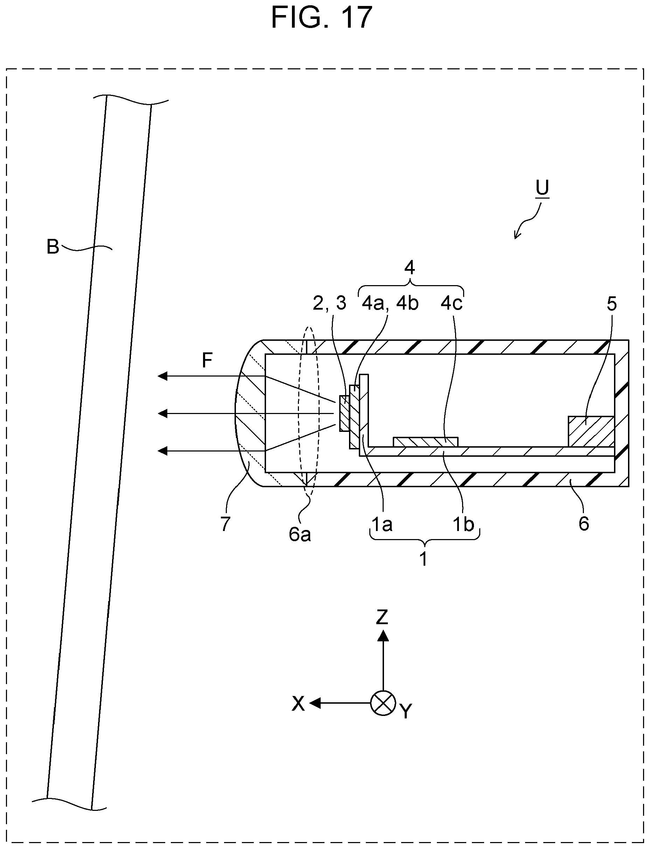

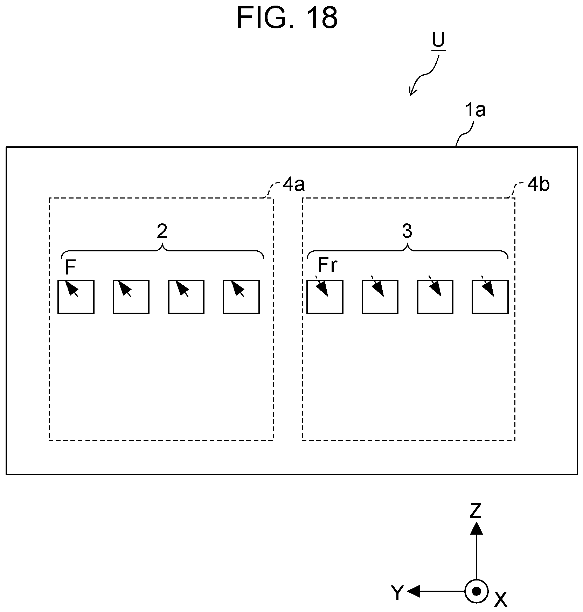

Next, an example of the structure of an antenna device U according to an eighth embodiment will be described with reference to Figs. 17 and 18.

Fig. 17 is a sectional side elevation of the antenna device U according to the eighth embodiment. Fig. 18 is a front view of the antenna device U according to the eighth embodiment when the front component side of the first circuit board part 1a is viewed from in front of the first circuit board part 1a.

The antenna device U according to this embodiment differs from the antenna device U according to the first embodiment in that the transmission antenna 2 and reception antenna 3 are mounted on a component side of the circuit board 1 integrally with the signal processing IC 4.

The transmission antenna 2 is mounted on a component side of the circuit board 1 in a state in which, for example, the transmission antenna 2 is incorporated into the package of the signal processing IC 4a, which performs signal processing involved in transmission processing in an extremely high frequency band. The reception antenna 3 is mounted on a component side of the circuit board 1 in a state in which, for example, the reception antenna 3 is incorporated into the package of the signal processing IC 4b, which performs signal processing involved in reception processing in an extremely high frequency band.

With the antenna device U according to this embodiment, it is possible to further shorten the lengths of the wires between the signal processing IC 4 and the transmission antenna 2 or reception antenna 3. Thus, it is possible to restrain analog signals in the wires from being distorted, contributing to improving the S/N ratio. It is also possible to reduce loss in electric power in the wires.

### Ninth embodiment

In the above embodiments, an antenna device has been taken as a target to which the antenna device U is applied. However, the antenna device U in the present disclosure can also be used in communication.

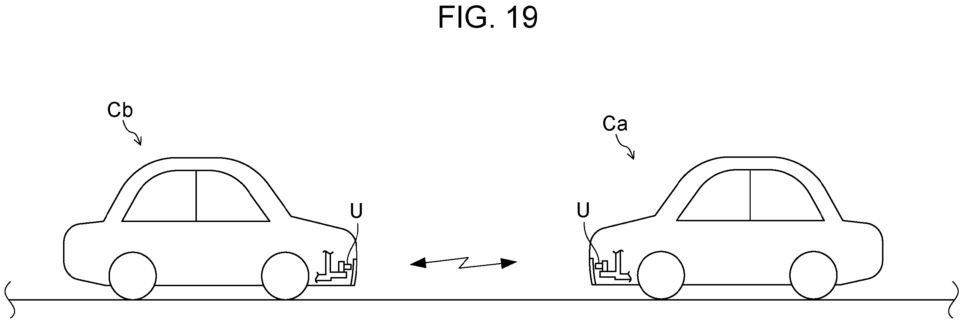

Fig. 19 illustrates an example in which an antenna device U according to a ninth embodiment is used in communication.

Fig. 19 illustrates a state in which an electromagnetic wave is sent and received to perform communication between the antenna device U mounted in a vehicle Ca and the antenna device U mounted in another vehicle Cb (so-called vehicle-vehicle communication). In the antenna device U according to this embodiment, it is only necessary to mount a signal processing IC (not illustrated) for communication use instead of the signal processing IC 4, described above, used to detect an object.

The antenna device U according to the present disclosure can efficiently send an electromagnetic wave in a desired direction in a case as well in which the electromagnetic wave is sent through the cover member B, so the antenna device U can also be used in an aspect in which communication is performed with another antenna device, as in this embodiment.

### Other embodiments

The present disclosure is not limited to the above embodiments but various modified aspects are possible. For example, various combinations of aspects indicated in the above embodiments may of course be used.

In the above embodiments, an aspect has been described in which as an example of a positional relationship between the first circuit board part 1a and the second circuit board part 1b on the circuit board 1, the direction in which the component sides of the first circuit board part 1a extend and the direction in which the component sides of the second circuit board part 1b extend are substantially orthogonal to each other. However, the present disclosure can of course be changed to an aspect in which the direction in which the component sides of the first circuit board part 1a extend and the direction in which the component sides of the second circuit board part 1b extend cross each other at a desired angle. In addition, the direction in which the component sides of the second circuit board part 1b extend may be inclined toward the Y or Z direction with respect to the front-back direction (X direction).

In the above embodiments, an aspect has been described in which as an example of a positional relationship between the circuit board 1 and cover member B, the direction in which the component sides of the second circuit board part 1b extend and the direction in which the cover member B extends are substantially orthogonal to each other. However, the present disclosure can of course be changed to an aspect in which the direction in which the component sides of the second circuit board part 1b extend and the direction in which the cover member B extends cross each other at a desired angle.

In the above embodiments, as an example of the antenna device U, an aspect in which the antenna device U has the dielectric lens 7 has been described. However, if there is no problem with gain in transmission and reception of an electromagnetic wave or with the shielding of a reflected wave intended to arrive at the reception antenna 3 from the cover member B, the antenna device U may lack the dielectric lens 7.

In the above embodiments, as an example of an aspect in which the antenna device U is applied, an aspect in which a region in front of the antenna device U is covered with the cover member B has been described. However, the antenna device U according to the present disclosure can of course be applied to an aspect in which a region in front of the antenna device U is not covered with the cover member B.

So far, specific examples of the present disclosure have been described in detail. However, these example are just exemplary of the present disclosure and do not restrict the scope of claims. Technologies described in the scope of claims include various modifications and changes of the above specific examples.

The antenna device according to the present disclosure can be used for the purpose of sending and receiving an electromagnetic wave through a cover member.

Each functional block used in the description of each embodiment described above can be partly or entirely realized by an large-scale integrated circuit (LSI) chip such as an integrated circuit, and each process described in the each embodiment may be controlled partly or entirely by the same LSI chip or a combination of LSI chips. The LSI chip may be individually formed as chips, or one chip may be formed so as to include part or all of the functional blocks. The LSI chip may include a data input and output coupled thereto. The LSI chip here may be referred to as an IC, a system LSI chip, a super LSI chip, or an ultra LSI depending on a difference in the degree of integration.

However, the technique of implementing an integrated circuit is not limited to the LSI chip and may be realized by using a dedicated circuit, a general-purpose processor, or a special-purpose processor. In addition, a field programmable gate array (FPGA) that can be programmed after the manufacture of the LSI chip or a reconfigurable processor in which the connections and the settings of circuit cells disposed inside the LSI chip can be reconfigured may be used. The present disclosure can be realized as digital processing or analogue processing.

If future integrated circuit technology replaces LSI chips as a result of the advancement of semiconductor technology or other derivative technology, the functional blocks could be integrated using the future integrated circuit technology. Biotechnology can also be applied.

## Claims

1. An antenna device having a case in which an opening is formed, the antenna device transmitting and receiving an electromagnetic wave through a cover member opposite to the opening, the device comprising:
a circuit board that has a first circuit board part having a component side opposite to the cover member and also has a second circuit board part extending in a direction perpendicular to the component side, the circuit board being disposed in the case;
a transmission antenna that sends the electromagnetic wave toward the cover member, the transmission antenna being disposed on the component side; and
a reception antenna that receives the electromagnetic wave, the reception antenna being disposed on the component side.

2. The antenna device according to Claim 1, further comprising a dielectric lens that narrows a beam of the electromagnetic wave sent from the transmission antenna, directs the narrowed beam to an outside of the antenna device, and focuses the electromagnetic wave from the outside of the antenna device onto the reception antenna.

3. The antenna device according to Claim 2, wherein the dielectric lens converts the electromagnetic wave sent from the transmission antenna to a plane wave.

4. The antenna device according to Claim 2, wherein the dielectric lens is formed from a convex lens having a convex shape on a front surface.

5. The antenna device according to Claim 1, wherein the transmission antenna and the reception antenna are each formed from a conductive pattern formed on the component side of the circuit board.

6. The antenna device according to Claim 5, wherein the transmission antenna and the reception antenna are each a patch antenna.

7. The antenna device according to Claim 1, further comprising a signal processor that infers a direction toward a target according to a reflected wave from the target, the reflected wave being part of the electromagnetic wave sent from the transmission antenna.

8. The antenna device according to Claim 7, wherein the signal processor is mounted on a rear side of the first circuit board part, the signal processing being electrically connected to at least one of the transmission antenna and the reception antenna.

9. The antenna device according to Claim 7, wherein the signal processor is mounted integrally with the transmission antenna or the reception antenna.

10. The antenna device according to Claim 1, further comprising a reflector that reflects a back lobe of the electromagnetic wave sent from the transmission antenna, the reflector being placed on a side of the first circuit board part, the side being opposite to a side, of the first circuit board part, on which the transmission antenna is mounted.

11. The antenna device according to Claim 1, wherein the first circuit board part is placed in a front region on the component side of the second circuit board part or in front of the second circuit board part.

12. The antenna device according to Claim 1, further comprising a bracket that secures the case to the cover member placed so as to cover an outside region in front of the case to define a direction in which the antenna device sends the electromagnetic wave to the outside of the antenna device.

13. The antenna device according to Claim 12, wherein the bracket secures the case to the cover member so that the direction in which the antenna device sends the electromagnetic wave to the outside of the antenna device is parallel to ground.

14. The antenna device according to Claim 12, wherein the bracket is made of an electromagnetic wave absorbing material or a material including an electromagnetic wave absorbing material.

15. The antenna device according to Claim 1, wherein the case includes a metal material.

16. The antenna device according to Claim 1, wherein a length of the case in an up-down direction is shorter than a length of the case in a front-back direction, the up-down direction being a direction normal to the component side of the second circuit board part.

17. The antenna device according to Claim 1, wherein the case has a connecting part that thermally bonds the case to the circuit board or to a circuit component mounted on the circuit board.

18. The antenna device according to Claim 1, wherein a wall region of the case, the wall region not allowing the electromagnetic wave to transmit through the wall region, extends to a position in front of positions at which the transmission antenna and the reception antenna are placed.

19. The antenna device according to Claim 1, wherein the antenna device is mounted in a vehicle.
